Europäisches Patentamt

European Patent Office

Office européen des brevets

(19)

(11) Numéro de publication: **0 145 549**
**B1**

(12) **FASCICULE DE BREVET EUROPEEN**

(45) Date de publication du fascicule du brevet: **11.05.88**

(21) Numéro de dépôt: **84402266.5**

(22) Date de dépôt: **09.11.84**

(51) Int. Cl.⁴: **H 05 K 1/00**

(54) **Carte imprimée à empreintes.**

(30) Priorité: **15.11.83 FR 8318133**

(43) Date de publication de la demande:
**19.06.85 Bulletin 85/25**

(45) Mention de la délivrance du brevet:
**11.05.88 Bulletin 88/19**

(84) Etats contractants désignés:
**DE FR GB IT NL SE**

(56) Documents cités:
**DE-A-2 327 530**
**DE-B-1 126 954**
**US-A-4 330 684**

(73) Titulaire: **THOMSON-CSF**
**173, Boulevard Haussmann**
**F-75379 Paris Cédex 08 (FR)**

(72) Inventeur: **Brault, Roland**
**THOMSON-CSF SCPI 173, bld Haussmann**
**F-75379 Paris Cedex 08 (FR)**

(74) Mandataire: **Ruellan-Lemonnier, Brigitte et al**
**THOMSON-CSF SCPI 19, avenue de Messine**
**F-75008 Paris (FR)**

Courier Press, Leamington Spa, England.

EP 0 145 549 B1

## Description

La présente invention concerne une carte imprimée à empreintes, plus particulièrement, une carte imprimée à empreintes sans implantation spécifique en fonction du schéma, destinée à être utilisée lors de la réalisation de dispositifs électroniques sous forme de circuits imprimés au stade maquette ou prototype.

Le circuit imprimé multicouche ne convenant pas en raison de la durée importante de conception et de la grande difficulté d'exécution des modifications, différentes techniques sont utilisées pour la réalisation de circuits imprimés au stade maquette ou prototype. Ces techniques utilisent des cartes imprimées à empreintes nécessitant une implantation spécifique ou non et différents types de câblage tels que le câblage en fil traditionnel, le "wrapping", le "multiwire" ou le câblage dit "ema-fil". Toutefois, ces techniques présentent de nombreux inconvénients.

Ainsi le câblage en fil traditionnel qui peut être réalisé sur une carte imprimée à enpreintes sans implantation spécifique, entraîne notamment une perte de place importante due à la nécessité d'avoir des trous pour insérer les fils de câblage, l'existence de "torons" posant des problèmes de couplage pour les signaux hautes fréquences, l'impossibilité de souder directement sur la carte des circuits hybrides du type à boitier plat aux emplacements prévus pour les boîtiers à double rangée de connexions ou boîtiers D.I.L.

Le câblage dit "ema-fil" nécessite pour chaque schéma une implantation spécifique des empreintes sur la carte imprimée ce qui entraîne des délais de réalisation relativement longs.

D'autre part, le brevet US—A—4330684 décrit une carte imprimée à empreintes utilisée lors de la réalisation de circuits au stade maquette ou prototype. Cette carte comporte une pluralité de trous disposés selon des colonnes. Dans chaque colonne le centre des trous est espacé de "0.10 inch" et les colonnes sont espacées entre elles de n fois "0.10 inch", n égalant 1, 2 ou 3. Dans ce cas, le câblage est réalisé par "wire wrapping". Dans ce cas, le câblage est long et délicat.

La présente invention a, en conséquence, pour but de remédier à ces inconvénients en proposant une nouvelle structure de carte imprimée à empreintes qui permet d'atteindre les résultats suivants:

—suppression du délai de réalisation du circuit imprimé;

—utilisation indifférente de plusieurs types de boitiers D.I.L. ou de boîtiers plats;

—obtention d'une forte densité de circuits au $dm^2$;

—très faible volume du câblage;

—facilité de réalisation des modifications et des mises au point;

—possibilité de câblage automatique.

La présente invention a donc pour objet une carte imprimée à empreintes comportant une face composants et une face câblage cette carte étant munie de plusieurs rangées de trous conducteurs espacées d'un multiple d'un pas constant et disposées selon un motif répétitif, caractérisé en ce que chaque trou conducteur est relié à une pastille de câblage conductrice prévue sur la face câblage à l'intérieur du motif.

D'autres caractéristiques et avantages de la présente invention apparaîtront à la lecture de la description d'un mode de réalisation préférentiel faite avec référence aux dessins ci-annexés dans lesquels:

—la figure 1 est une vue en plan de dessus partiellement éclatée d'une carte imprimée à empreintes conforme à la présente invention;

—la figure 2 est une vue en plan de dessous partiellement éclatée de la carte de figure 1;

—la figure 3 est une vue en coupe par III—III de figure 1;

—la figure 4 est une vue en plan de dessus montrant les diverses possibilités d'implantation de boitiers D.I.L;

—la figure 5 est une vue semblable à celle de la figure 4 pour des boitiers plats, et

—la figure 6 est une vue semblable à celle de la figure 4 pour des composants discrets.

Dans les figures, les mêmes références désignent les mêmes éléments mais pour des raisons de clarté les cotes et proportions des divers éléments n'ont pas été respectées.

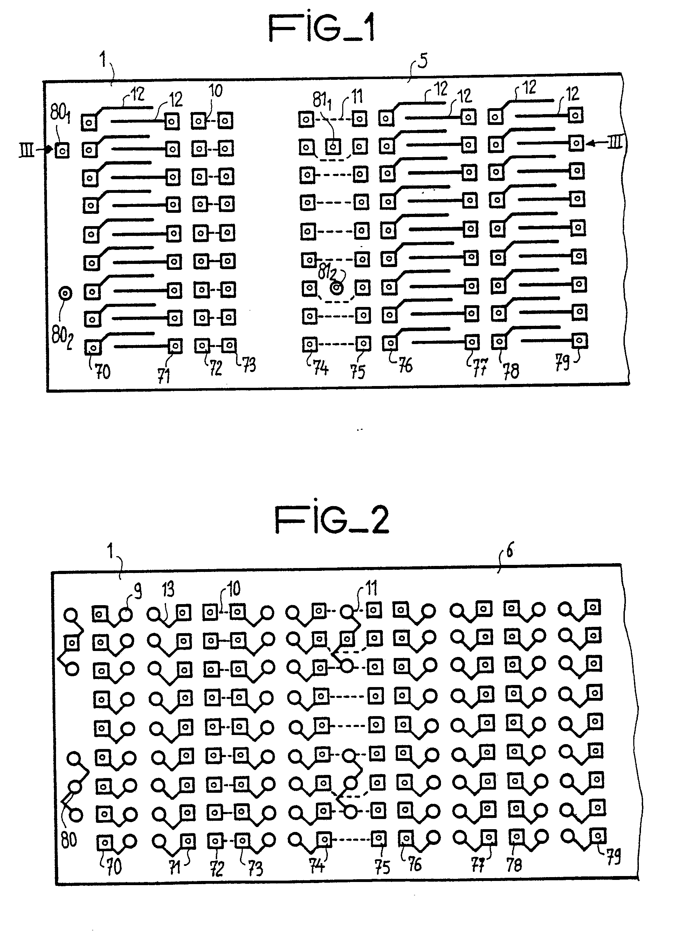

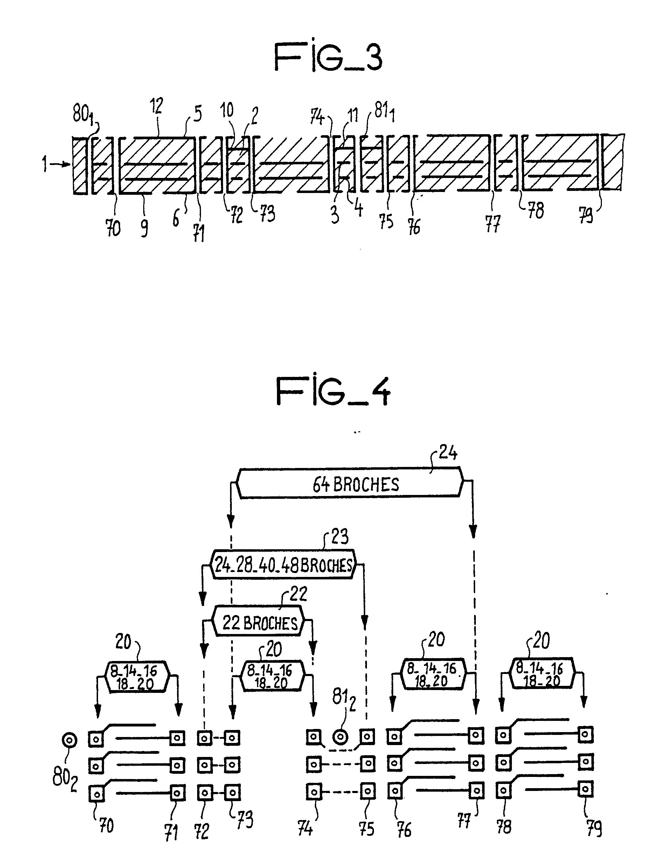

Les figures 1 à 3 représentent un mode de réalisation préférentiel d'une carte imprimée à empreintes conforme à la présente invention. Comme représenté sur la figure 3, la carte imprimée à empreintes est une carte multicouche comportant cinq couches conductrices à savoir trois couches internes 2, 3, 4 et deux couches externes 5, 6 à savoir la face composants et la face câblage.

Conformément à la présente invention, la carte imprimée 1 est munie de plusieurs rangées 70 à 79, 80 et 81 de trous conducteurs, constitués de préférence par des trous métallisés. Les différentes rangées de trous conducteurs sont espacées d'un multiple d'un pas de 2, 54 millimètres et sont disposées selon un motif répétitif. Le pas de 2, 54 millimètres a été choisi pour correspondre aux dimensions actuelles des boitiers D.I.L et des boitiers plats qui doivent être montés sur les cartes imprimées. Le motif répétitif du mode de réalisation représenté est un motif réalisé sur vingt pas de 2, 54 millimètres. Il est constitué essentiellement par dix rangées 70 à 79 de trous destinés à recevoir les broches des circuits et par deux rangées 80 et 81 de trous pour les connexions à l'alimentation et à la masse. Les rangées de trous destinées à recevoir les broches des circuits sont constituées de trous espacés de 2, 54 millimètres tandis que les rangées de trous destinées à l'alimentation et au découplage sont constituées de trous $80_1$, $80_2$ ou $81_1$, $81_2$ espacées de cinq pas de 2,54 millimètres.

Afin de recevoir des boitiers D.I.L de différentes largeurs, les trous métallisés de certaines rangées contigües telles que les rangées 72 et 73 ou 74 et 75 sont connectés ensemble par l'intermédiaire de liaisons internes 10 et 11 réalisées sur la deuxième couche conductrice 2. De même, pour pouvoir recevoir sans perte de place, les différentes boitiers plats, les trous de certaines rangées contigües telles que les rangées 70 et 71, 76, 77, 78, 79 sont connectés à des pistes de câblage 12 prévues sur la face composants 5 de la carte 1. Les pistes de câblage 12 de deux rangées contigües de trous métallisés sont réalisées de manière a être parallèles les unes avec les autres et espacées d'un demi-pas, à savoir de 1, 27 millimètre pour pouvoir recevoir les circuits hybrides en boitiers plats dont les broches sont au pas de 1, 27 millimètre.

De ce fait, le motif répétitif du mode de réalisation représenté est constitué d'une première rangée 80 de trous pour l'alimentation et le découplage comportant un trou d'alimentation $80_1$ connecté au plan alimentation réalisé sur la couche conductrice interne 3 et un trou de découplage $80_2$ connecté au plan de masse réalisé sur la couche conductrice interne 4. Cette rangée 80 de trous est espacée d'un pas d'une première rangée 70 de trous destinés à recevoir les broches des différents circuits ou composants. Les trous de la rangée 70 sont reliés chacun à une piste de câblage 12 pour boitiers plats et cette rangée est espacée de trois pas de la seconde rangée 71 dont les trous sont reliés à une piste de câblage 12. A une distance d'un pas de la rangée 71 de trous est prévue une troisième rangée 72 de trous. Cette rangée 72 de trous est elle-même espacée de la rangée 73 de trous d'un pas. Les trous des rangées 72 et 73 sont connectés ensemble par les liaisons 10. Ensuite à une distance de trois pas est prévue une cinquième rangée 74 de trous dont les trous sont reliés par les liaisons 11 aux trous d'une sixième rangée 75 de trous espacée de deux pas. Entre les rangées 74 et 75 est prévue une seconde rangée de trous d'alimentation et de découplage $81_1$, $81_2$ connectés au plan alimentation et au plan de masse de la même manière que la rangée de trous 80. Ensuite à un pas de la rangée 75 de trous est prévue une rangée 76 de trous reliés chacun à une piste de câblage 12. Cette rangée 76 de trous est espacée d'une distance de deux pas d'une rangée 77 dont les trous sont reliés à une piste de câblage 12. Les pistes de câblage reliées aux trous des rangées 76 et 77 sont parallèles entre elles et espacées d'un pas de 1,27 millimètre. Une rangée 78 de trous est prévue à un pas de la rangée 77. Les trous de cette rangée 78 sont reliés à une piste de câblage 12. Cette rangée est espacée d'une distance de trois pas, d'une rangée 79 de trous dont les trous sont aussi reliés à une piste de câblage 12, les pistes de câblage des rangées 78 et 79 étant parallèles les unes aux autres et espacées d'un demi pas.

Comme représenté sur la figure 2 chaque trou métallisé est relié directement par l'intermédiaire d'une liaison 13 ou indirectement par l'intermédiaire des liaisons internes 10, 11 à une pastille de câblage. Les pastilles de câblage sont toutes disposées à l'intérieur du motif décit ci-dessus.

Le motif répétitif décrit ci-dessus se répète un certain nombre de fois. En fait le nombre de trous dans une rangée et le nombre de motifs répétitifs ne sont limités que par le format de la carte 1 pour circuit imprimé.

La carte imprimée à empreintes décrite ci-dessus est réalisée selon les méthodes de fabrication usuelles bien connues de l'homme de l'art. En conséquence ces méthodes de fabrication ne seront pas redécrites ici.

On décrira maintenant avec référence aux figures 4 à 6 les différentes possibilités d'implantation qui peuvent être réalisées avec la carte imprimée à empreintes conforme à la présente invention.

Comme représenté sur la figure 4, il est possible d'implanter différents types de boitiers DIL sur la carte imprimée à empreintes de la présente invention 1. Ainsi, comme représenté sur la figure 4 qui concerne l'implantation des boitiers DIL, un motif permet d'insérer:

—quatre rangées de boitiers DIL 20 de 8, 14, 16, 18, 20 broches présentant une largeur de trois pas, ou bien,

—trois rangées de boitiers DIL 20 de 8, 14, 16, 18 ou 20 broches et une rangée de boitiers DIL de 22 broches présentant une largeur de quatre pas ou une rangée de boitiers DIL 23, de 24, 28, 40, 48 broches présentant une largeur de six pas, ou bien une rangée de boitiers DIL 20, et deux rangées de boitiers DIL 22;

—deux rangées de boitiers DIL 20 et une rangée de boitiers DIL 23 ou bien deux rangées de boitiers DIL 20, et une rangée de boitiers DIL 24 de 64 broches présentant une largeur de neuf pas.

L'insertion de boitiers DIL de largeurs différentes à un même emplacement est rendue possible par le fait que les trous de certains couples de rangées 72, 73, 74 et 75 sont connectés entre eux par des liaisons internes 10, 11.

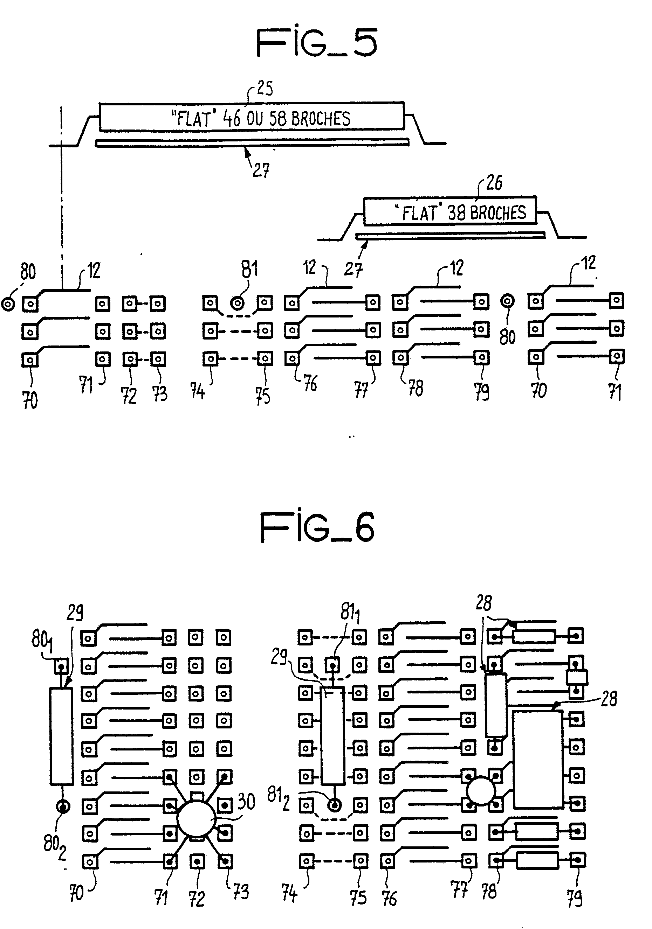

Comme représenté sur la figure 5, la carte imprimée de la présente invention permet l'implantation de ceratins circuits hybrides en boitiers plats dont les broches sont réparties en deux rangées parallèles avec un pas de 1,27 millimètre. Les boitiers plats 25 à 46 ou 58 broches ainsi que les boitiers plats 26 à 38 broches sont montés sur la face composants 5 de la carte imprimée de telle sorte que leurs broches soient au contact des pistes de câblage 12. Une plaque isolante 27 est prévue entre les boitiers plats et la face composants 5 de la carte imprimée.

Comme représenté sur la figure 6, des éléments discrets tels que des capacités de découplage 29, des résistances 28, des transistors 30 ou similaires peuvent aussi être implantés sur la carte imprimée de la présente invention. Les capacités de découplage 29 sont notamment montées dans les rangées de trous 80, 81 reliées au plan alimentation et au plan masse.

On donnera maintenant divers exemples d'implantation montrant les avantages de la carte imprimée de la présente invention au niveau en particulier de la densité d'implantation. Les exemples ci-après concernent les cartes à empreintes de 4 dm² (286×138 millimètres). La surface implantable est d'environ 3,3 dm².

Exemple 1:

sur cette carte ont été implantés les boitiers DIL suivants, l'implantation étant donnée en équivalent de boitiers 16 broches pour comparaison;

1 boitier 64 broches équivalant à 9 boitiers 16 broches,

10 boitiers 24 broches équivalant à 28 boitiers 16 broches,

4 boitier 22 broches équivalant à 8 boitiers 16 broches,

22 boitiers 14 broches équivalant à 19 boitiers 16 broches,

31 boitiers 16 broches équivalant à 31 boitiers 16 broches,

26 boitiers 20 broches équivalant à 32 boitiers 16 broches,

1 boitier 18 broches équivalant à 1 boitier 16 broches.

Cette implantation correspond à une densité de 38 équivalents 16 broches au dm². 

Exemple 2

18 boitiers 22 broches équivalant à 36 boitiers 16 broches,

11 boitiers 14 broches équivalant à 9 boitiers 16 broches,

49 boitiers 16 broches équivalant à 49 boitiers 16 broches,

13 boitiers 16 broches équivalant à 16 boitiers 16 broches,

7 emplacements disponibles équivalant à 7 boitiers 16 broches.

Cette implantation correspond à une densité de 35 équivalents 16 broches au dm². 

Exemple 3

23 boitiers 14 broches équivalant à 21 boitiers 16 broches,

20 boitiers 16 broches équivalant à 20 boitiers 16 broches,

6 boitiers 24 broches équivalant à 7 boitiers 16 broches,

20 boitiers 18 broches équivalant à 23 boitiers 16 broches,

2 boitiers plats à 58 broches équivalant à 18 boitiers 16 broches.

4 boitiers plats à 46 broches équivalant à 28 boitiers 16 broches.

Cette implantation correspond à une densité de 38 équivalents 16 broches au dm². 

De manière générale on peut considérer que la carte à empreintes conforme à la présente invention permet de réaliser des cartes dépassant une densité de 30 équivalents 16 broches au dm². Cette densité est comparable au densité permise par les circuits imprimés multicouches.

La carte imprimée à empreintes conforme à la présente invention permet donc de réaliser des circuits au stade prototype ou maquette rapidement et dans le volume qui sera occupé par le matériel définitif. La technique de câblage utilisée avec ce type de carte est la technique "ema-fil" ou éventuellement "multiwire".

Dans la description ci-dessus on a utilisé une carte imprimée à cinq couches conductrices toutefois il est évident pour l'homme de l'art que l'on pourrait utiliser une carte imprimée à quatre couches conductrices, les liaisons internes 10 et 11 étant réalisées sur la face composants 5 de la carte imprimée. Il serait même possible sans sortir du cadre de la présente invention de réaliser la carte imprimée avec une carte imprimée double face.

D'autre part, le motif répétitif permet l'implantation d'une grande variété de boitiers DIL et de circuits hybrides en boitiers plats. Toutefois ce motif répétitif peut être adapté à d'autres types de boitiers susceptibles d'être implantés sur des cartes imprimées et cela sans sortir du cadre de la présente invention.

**Revendications**

1. Une carte imprimée à empreintes comportant une face composants (5) et une face câblage (6), cette carte étant munie de plusieurs rangées (70 à 79, 80, 81) de trous conducteurs espacées d'un multiple d'un pas constant et disposées selon on motif répétitif, caractérisé en ce que chaque trou conducteur est relié à une pastille de câblage (9) prévue sur la face câblage (6) à l'intérieur du motif.

2. Une carte selon la revendication 1 caractérisée en ce que chaque motif comporte au moins un trou conducteur ($80_1$, $81_1$) connecté à l'alimentation et un trou conducteur ($80_2$, $81_2$) connecté à la masse.

3. Une carte selon l'une quelconque des revendications 1 à 2 caractérisée en ce que les trous correspondants de certaines rangées contigües (72, 73, 74, 75) sont connectés ensemble et reliés à la même pastille de câblage (9).

4. Une carte selon l'une quelconque des revendications 1 à 3 caractérisée en ce que les trous de certaines rangées (70, 71, 76, 77, 78, 79) contigües sont connectés à des pistes de câblage (12) prévues sur la face composants de la carte.

5. Une carte selon la revendication 4 caractérisée en ce que les pistes (12) de deux rangées contigües sont parallèles et espacées d'un demi-pas.

6. Une carte selon l'une quelconque des revendications 1 à 5 caractérisée en ce que les trous de chaque rangée (70 à 79, 80, 81) sont espacés d'un multiple du pas constant.

7. Une carte selon l'une quelconque des revendications 1 à 6 caractérisée en ce qu'elle est constituée par une carte multicouche comportant une couche alimentation (3) et une couche masse (4).

8. Une carte selon la revendication 7 caractérisée en ce qu'elle comporte une couche supplémentaire (16) pour les liaisons (10, 11) entre certaines rangées (72, 73, 74, 75) de trous contigües.

**Patentansprüche**

1. Gedruckte Rasterplatte mit einer Bestückungsfläche (5) und einer Verdrahtungsfläche (6), wobei diese Platte mit mehreren Reihen (7 bis 79, 80, 81) durchkontaktierter Löcher versehen ist, wobei diese Reihen um ein Vielfaches eines konstanten Teilungsschrittes beabstandet und nach einem sich wiederholenden Muster angeordnet sind, dadurch gekennzeichnet, daß jedes durchkontaktierte Loch mit einem Verdrahtungsplättchen (9) verbunden ist, das auf der Verdrahtungsfläche (6) im Inneren des Musters vorgesehen ist.

2. Platte nach Anspruch 1, dadurch gekennzeichnet, daß jedes Muster mindestens ein durchkontaktiertes Loch ($80_1$, $81_2$), welches mit der Stromversorgung verbunden ist, und ein durchkontaktiertes Loch ($80_2$, $81_2$), welches mit der Masse verbunden ist, aufweist.

3. Platte nach einem der Ansprüche 1 bis 2, dadurch gekennzeichnet, daß die einander entsprechenden Löcher bestimmter aneinander angrenzender Reihen (72, 73, 74, 75) miteinander und mit demselben Verdrahtungsplättchen (9) verbunden sind.

4. Platte nach einem der Ansprüche 1 bis 3, dadurch gekennzeichnet, daß die Löcher bestimmter aneinander angrenzender Reihen (70, 71, 76, 77, 78, 79) mit Verdrahtungsbahnen (12), welche auf der Bestückungsfläche der Platte vorgesehen sind, verbunden sind.

5. Platte nach Anspruch 4, dadurch gekennzeichnet, daß die Bahnen (12) von zwei aneinander angrenzenden Reihen parallel und um einen halben Teilungsschritt beabstandet sind.

6. Platte nach einem der Ansprüche 1 bis 5, dadurch gekennzeichnet, daß die Löcher jeder Reihe (70 bis 79, 80, 81) um ein Vielfaches des konstanten Teilungsschrittes beabstandet sind.

7. Platte nach einem der Ansprüche 1 bis 6, dadurch gekennzeichnet, daß sie aus einer mehrschichtigen Platte besteht, welche eine Stromversorgungsschicht (3) und eine Masseschicht (4) aufweist.

8. Platte nach Anspruch 7, dadurch gekennzeichnet, daß sie eine zusätzliche Schicht (6) für die Verbindungen (10, 11) zwischen bestimmten aneinander angrenzenden Reihen (72, 73, 74, 75) von Löchern aufweist.

**Claims**

1. A preprinted circuit board comprising a component surface (5) and a wiring surface (6), said board being furnished with a plurality of banks (70 to 79, 80 and 81) of conducting holes spaced by a multiple of a constant pitch and arranged in a repeating pattern, characterized in that each conducting hole is connected with a land (9) for wiring provided on the wiring surface (6) within the pattern.

2. The board as claimed in claim 1 characterized in that each pattern comprises at least one conducting hole ($80_1$ and $81_1$) connected with a supply and a conducting hole ($80_2$ and $81_2$) connected with ground.

3. The board as claimed in either claim 1 or claim 2 characterized in that the corresponding holes of certain contiguous banks (72, 73, 74 and 75) are connected together and connected with the same wiring land (9).

4. The board as claimed in any one of the claims 1 to 3 characterized in that the holes of certain contiguous banks (70, 71, 76, 77, 78 and 79) are connected with wiring tracks (12) provided on the component surface of the board.

5. The board as claimed in claim 4 characterized in that the tracks of two contiguous banks are parallel and spaced by half the pitch.

6. The board as claimed in any one of the claims 1 to 5 characterized in that the holes of each bank (70 to 79, 80 and 81) are spaced by a constant multiple of the pitch.

7. The board as claimed in any one of the claims 1 to 6 characterized in that it is constituted by a multilayer board comprising a supply layer (3) and a ground layer (4).

8. The board as claimed in claim 7 characterized in that it comprises a supplementary layer (6) for the connections (10 and 11) between certain banks (72, 73, 74 and 75) of the contiguous holes.

# FIG_1

# FIG_2

**0 145 549**

# FIG_3

# FIG_4

# FIG_5

25

"FLAT" 46 OU 58 BROCHES

27

26

"FLAT" 38 BROCHES

27

80  12     81     12     12     12

70   71   72  73   74   75   76   77   78   79   70   71

# FIG_6

29   81₁   28

80₁

29

28

30   81₂   28

80₂

70   71   72   73   74   75   76   77   78   79